Europäisches Patentamt

European Patent Office

Office européen des brevets

(19)

(11) Veröffentlichungsnummer: **0 232 880 B1**

## (12) EUROPÄISCHE PATENTSCHRIFT

(45) Veröffentlichungstag der Patentschrift: **09.10.91**

(51) Int. Cl.⁵: **G11B 9/04**

(21) Anmeldenummer: **87101742.2**

(22) Anmeldetag: **09.02.87**

(54) **Medium zur irreversiblen Informationsspeicherung sowie Verfahren zu seiner Durchführung.**

(30) Priorität: **14.02.86 DE 3604568**

(43) Veröffentlichungstag der Anmeldung:
**19.08.87 Patentblatt 87/34**

(45) Bekanntmachung des Hinweises auf die
Patenterteilung:
**09.10.91 Patentblatt 91/41**

(84) Benannte Vertragsstaaten:
**DE FR GB NL**

(56) Entgegenhaltungen:
**GB-A- 1 088 117**

(73) Patentinhaber: **BASF Aktiengesellschaft
Carl-Bosch-Strasse 38
W-6700 Ludwigshafen(DE)**

(72) Erfinder: **Wisseroth, Karl Dr.
Brucknerstrasse 5
W-6700 Ludwigshafen(DE)**
Erfinder: **Scholl, Richard
Nordring 7
W-6718 Gruenstadt(DE)**

Rank Xerox (UK) Business Services

## Beschreibung

Die Erfindung betrifft ein Medium zur irreversiblen Informationsspeicherung durch lokale Änderung der elektrischen Leitfähigkeit eines Trägermaterials, dessen diskrete Bereiche der elektrischen Leitfähigkeit auf dem Wege feldchemischer Umsetzung erzeugt wurden sowie ein Verfahren zur Durchführung dieser Informationsspeicherung.

Es ist bekannt, Information auf magnetischen Aufzeichnungsträgern dadurch zu speichern, daß diskrete Bereiche unterschiedlicher Magnetisierung in den magnetisierbaren Schichten erzeugt werden. Hierzu können die magnetisierbaren Schichten entweder aus in organischen Bindemitteln gleichmäßig verteilten ferri- oder ferromagnetischen Teilchen oder unmittelbar aus einer homogenen Schicht eines ferri- oder ferromagnetischen Materials bestehen. Die erstgenannten magnetischen Aufzeichnungsträger sind seit langem bekannt und auf dem Audio-, Video- und Datengebiet in vielfacher Weise genutzt. Ihre Herstellung ist weitgehend optimiert. Die Grenzen ihrer Nutzung dürfen sich hinsichtlich der maximal möglichen Speicherdichte ergeben. Um diese zu erweitern werden in zunehmendem Maße homogene Schichten ferromagnetischer Materialien untersucht und bei der Daten- und Videoaufzeichnung auch schon eingesetzt. Den Vorteilen bei den magnetischen Eigenschaften und der Speichertechnik stehen jedoch noch Probleme bezüglich der mechanischen Stabilität dieser Medien entgegen.

Um die prinzipiell gegebenen Grenzen der Speicherdichte bei magnetischen Aufzeichnungsträgern zu überwinden, wurde bereits die optische Informationsspeicherung in Betracht gezogen. Die optische Informationsspeicherung beruht auf der Erzeugung von Markierungen auf einem Medium durch Lichteinwirkung. Bereits im Stadium der technischen Realisierung befindet sich die irreversible optische Speicherung bei der mit einem Laserstrahl als Lichtquelle nicht mehr veränderbare Markierungen auf einem meist plattenförmigen Medium erzeugt werden. Durch die Bestrahlung ändert sich die optische Eigenschaft der Aufzeichnungsschicht, vornehmlich die Reflektivität oder Absorption. Die Markierung ist ein sogenanntes "eingebranntes Loch" in der Aufzeichnungsschicht. Das Lesen erfolgt ebenfalls mit einem Laser, wobei die Laserenergie aber wesentlich geringer gewählt wird. Als Medien sind homogene, partikulär zweidimensionale und partikulär dreidimensionale Schichten bekannt. Die hierfür eingesetzten Materialien sind vielfältig, meist spezielle Halbmetalle oder Metalle. Hinsichtlich der homogenen Schichten bestehen die Nachteile, daß die Metallschichten einerseits wegen der nötigen geringen Wärmeleitfähigkeit sehr dünn sein müssen und andererseits es dadurch sehr schwierig ist, fehlerfreie Filme ohne Poren und Löcher herzustellen. Die partiuklären Schichten haben den Nachteil, daß sowohl die Herstellung der Metallpartikel als auch die gleichmäßige Einlagerung der Partikel in eine Matrix problematisch ist.

Aus der Druckschrift GB-A- 1 088 117 ist ein Aufzeichnungsverfahren bekannt, bei dem in einem Speichermedium entsprechend der aufzuzeichnenden Information die elektrische Leitfähigkeit verändert wird.

Aufgabe der vorliegenden Erfindung ist es, ein Medium zur irreversiblen Informationsspeicherung bereitzustellen, das sowohl eine weitere Steigerung der Speicherdichte über das bekannte Maß in den molekularen Bereich hinein ermöglicht und zum andern mit einfachen Mitteln beschrieben als auch wieder ausgelesen werden kann und ein Verfahren zu finden, das diese Art der Informationsspeicherung ermöglicht.

Diese Aufgabe wird durch die Merkmale der unabhängigen Patentansprüche gelöst.

Es wurde nun gefunden, daß sich ein Medium zur irreversiblen Informationsspeicherung in überraschend einfacher Weise durch lokale Änderung der elektrischen Leitfähigkeit eines Trägermaterials aufgabengemäß erhalten läßt, wenn die diskreten Bereiche der elektrischen Leitfähigkeit des Trägermaterials mittels der durch feldchemische Umsetzung entstehender polymerer Systeme mit konjugierten Doppelbindungen erzeugt werden.

Gegenstand der Erfindung ist außerdem ein Verfahren zur Informationsspeicherung mittels feldchemischer Umsetzung, wobei zwischen den nadelartigen Spitzen zweier Elektroden auf blatt- oder folienartige Träger aufgebrachte Stoffe durch Einwirkung von zumindest lokalen elektrischen Feldern mit Feldstärken von größer $10^6$ Volt/cm zu polymeren Systemen mit konjugierten Doppelbindungen, die elektrische Leitfähigkeit aufweisen, umngesetzt werden, mit der Maßgabe, daß die Spitzen der Elektroden in einem gegenseitigen Abstand angeordnet sind, welcher mindestens der Dicke des Trägers entspricht und die beiden Elektroden in Reihenschaltung über mindestens einen Kondensator an eine Hochspannungsversorgung von 1000 bis 100 000 Volt angeschlossen sind.

Die Durchführung chemischer Reaktionen unter Einwirkung genügend starker elektrischer Felder, im allgemeinen im Bereich von $10^7$ bis $10^9$ Volt/cm ist bekannt (z.B. K. Wisseroth, Nachrichten aus Chemie, Technik und Labor 27 (1979), 327-328 und Chemiker-Zeitung 108 (1984) 131-135). Diese Art von Reaktionen werden als feldchemische Reaktionen bezeichnet. Die hohen elektrischen Felder bewirken dabei eine katalytische Beschleunigung der Umsetzung.

Die erfindungsgemäßen Medien tragen nun auf oder in dem Trägermaterial die gespeicherte Information in Form der den einzelnen Informationseinheiten zugeordneten Bereiche unterschiedlicher elektrischer Leitfähigkeit. Diese Bereiche werden gemäß dem erfindungsgemäßen Verfahren erzeugt.

Geeignet für eine chemische Umsetzung zur Informationsspeicherung im elektrischen Feld erweist sich die Bildung polymerer Systeme mit konjugierten Doppelbindungen. So sind besonders geeignet Polyaniline, Polyindamine, polymere Azokörper und insbesondere die Polyacetylene oder Kuprene. Diese Systeme sind auch als "organische Metalle" bekannt, indem Bezug genommen wird auf die hohe Beweglichkeit der die konjugierten Doppelbindungen bildenden Elektronen, was zu metallartiger elektrischer Leitfähigkeit längs der Molekülkette führt. Eine mit den beispielsweise zuerst genannten Polymeren bedeckte Trägermatrix erhält in der Regel elektrische Leitfähigkeit erst nach zusätzlicher Dotierung mit weiteren Stoffen, wie z.B. Anilin oder Dioxan. Dagegen zeigen die Polyacetylene nach feldchemischer Erzeugung durch Polymerisation von monomerem Acetylen oder seiner Derivate je nach Intensität der einwirkenden Feldstäre unmittelbar mehr oder weniger stark ausgebildete Leitfähigkeit. Die so erzeugten Produkte weisen insbesondere bezüglich ihrer Leitfähigkeit keinerlei zeitliche Beeinträchtigung, auch nicht nach längerem Kontakt mit der Atmosphäre.

Die angeführten Umsetzungen lassen sich sowohl aus der Gasphase, wie z.B. mit Acetylen, als auch aus flüssiger Phase, wie z.B. mit Phenylacetylen oder auch in der festen Phase, wie z.B. Diphenylacetylen, durchführen. Zu diesem Zweck wird das dünne Trägermaterial, z.B. eine Papiermatrix von etwa 100 μm, Bänder oder Scheiben von Folien verschiedener Kunststoffe, wie Polyolefine, Polyamide sowie insbesondere Polyvinylchlorid, mit dem umzusetzenden Monomeren getränkt oder beaufschlagt und zwischen den Spitzen der Schreibelektroden hindurchgeführt, zwischen denen die zur feldchemischen Umsetzung erforderlichen Feldstärken in einer der einzuschreibenden Information entsprechenden Folge erzeugt werden. Die Spurbreite der aufgezeichneten Information ergibt sich im wesentlichen aus dem Spitzendurchmesser der Schreibelektroden. Geringe Spurbreiten, prinzipiell bis in den Ångström-Bereich, sind einstellbar durch Verwendung feiner Wolframspitzen, wie sie etwa nach der Müller'schen Methode zur Verwendung im Feldelektronenmikroskop durch Ätzen in geschmolzenem Alkali herstellbar sind.

Bei einer Aufladung der Spitzen mit einem Krümmungsradius beispielsweise von 0,01 Millimetern auf ein Potential von beispielsweise 10 000 Volt wird unmittelbar vor den Spitzen eine Feldstärke von

$$F = \frac{U}{r} = \frac{10^4}{10^{-3}} = 10^7 \text{ Volt/cm}$$

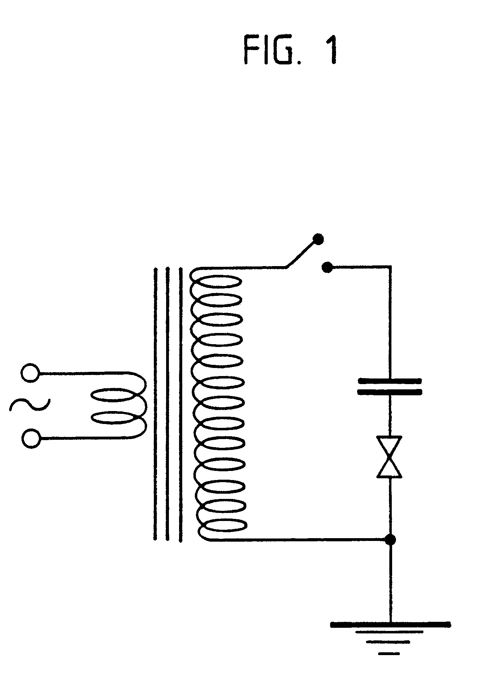

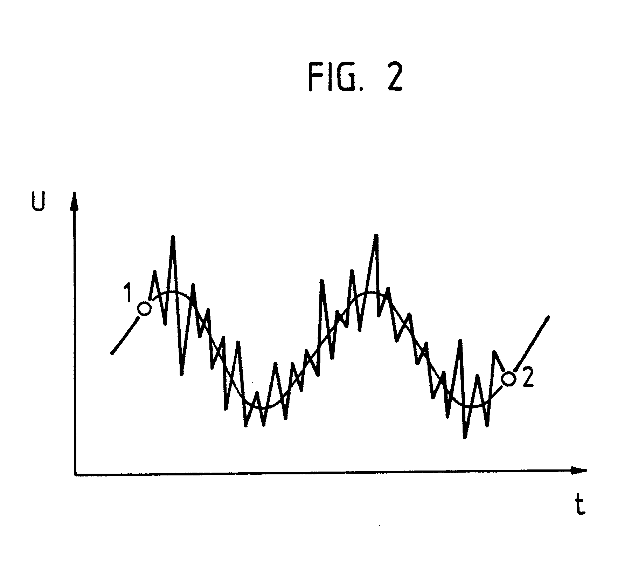

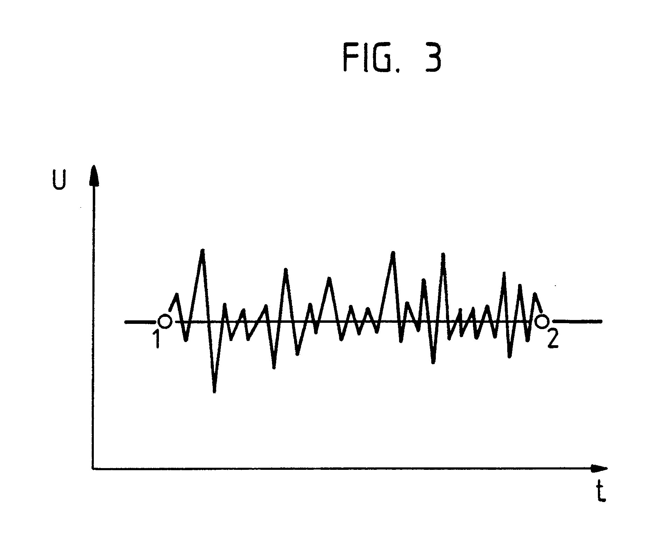

erhalten, also ein Wert bei dem bereits die angegebenen chemischen Reaktionen feldchemisch ausgelöst werden. Normalerweise würde das Potential mit Rücksicht auf den geringen Spitzenabstand rasch unter Ausbildung eines sogenannten Entladungs-Streamers, eines kleinen Plasmakanals zusammenbrechen. Aber auch im Plasma werden gemäß den Vorstellungen der Plasmachemie viele chemische Reaktionen beschleunigt. Um diesen Entladungszusammenbruch des Potentials aber möglichst zurückzudrängen, und damit außerdem die elektrische Leistung der Entladung weitgehend zu beschränken, werden in einer zweckmäßigen Ausgestaltung des erfindungsgemäßen Verfahrens die Entladungselektroden über mindestens einen Kondensator von genügend kleiner Kapazität an die Hochspannungsquelle angekoppelt. Figur 1 zeigt das grundsätzliche Schema einer solchen Anordnung. Die Spannungsversorgung kann dabei im Bereich zwischen etwa 1 000 bis 100 000 Volt vorgesehen werden. Die Modulation der Elektrodenaufladung ergibt für die Eingabe etwa einer gesprochenen Folge bei Wechsel- oder Gleichspannung die schematischen Darstellungen der Figuren 2 und 3. Hierin bezeichnen 1 und 2 jeweils Beginn und Ende der Sprachfolge.

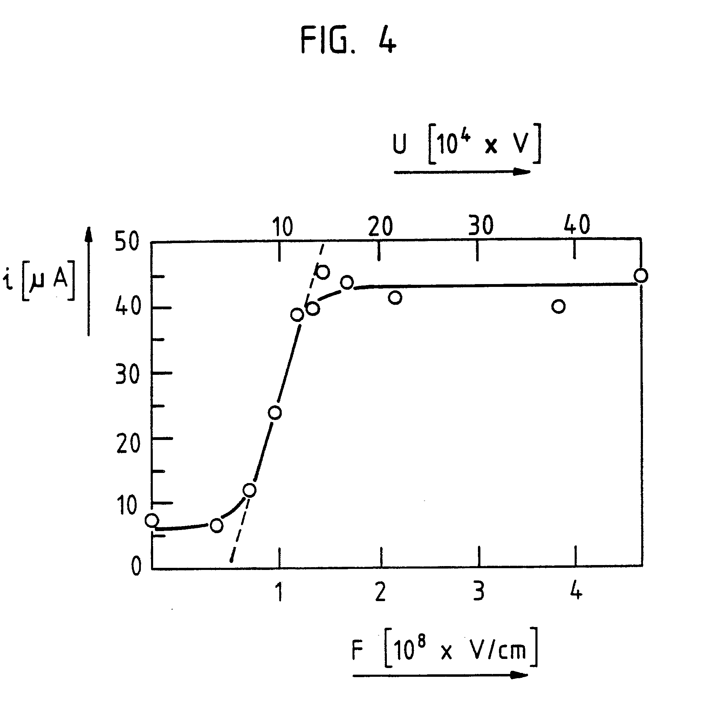

Unter sonst konstanten Bedingungen besteht zwischen der die Umsetzung bewirkenden Feldstärke F bzw. der ihr entsprechenden Spannung U und der dem Umsatz proportionalen Leitfähigkeit - bzw. einem ihr zur Messung dienendem Stromfluß i - ein charakteristischer Zusammenhang, der in Analogie zur Elektronenröhren- bzw. Transistorkennlinie als "Umsatzkennlinie" bezeichnet werde. Figur 4 zeigt als Beispiel diesen Zusammenhang für die Polyanilinbildung nach Dotierung mit Dioxan. Von besonderer Bedeutung erscheint dabei die "Steilheit" dieser Kennlinie im mittleren Bereich für die transformierende Aufzeichnung von Informationimpulsen. Entsprechende Verhältnisse werden u.a. auch bei der Polymerisation von Acetylen und seinen Derivaten zu Kuprenen beobachtet.

Die Intensität der eingeschriebenen Information kann sowohl von der vorgebbaren Spannung durch Regelung der Spannungsversorgung als auch über die Variation der Kapazitäten im Schreibelektrodenbereich beeinflußt werden. Der letztgenannte Einfluß bestimmt dabei auch die Deutlichkeit einer kontinuierlichen Strichführung, da sich mit zunehmender Kapazität die normalerweise zusammenhängende Strichführung perlenkettenartig zu diskontinuierlichen Niederschriften auflöst.

Die Erfindung sei anhand des folgenden Beispiels näher erläutert.

Beispiel

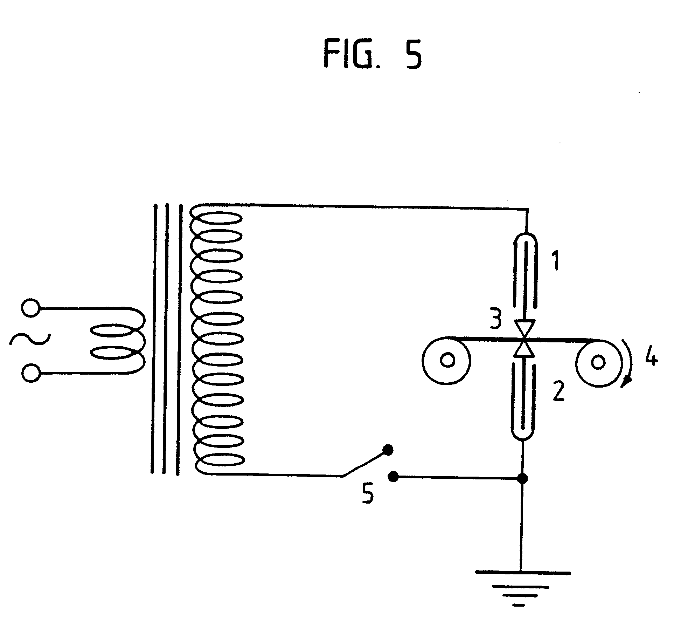

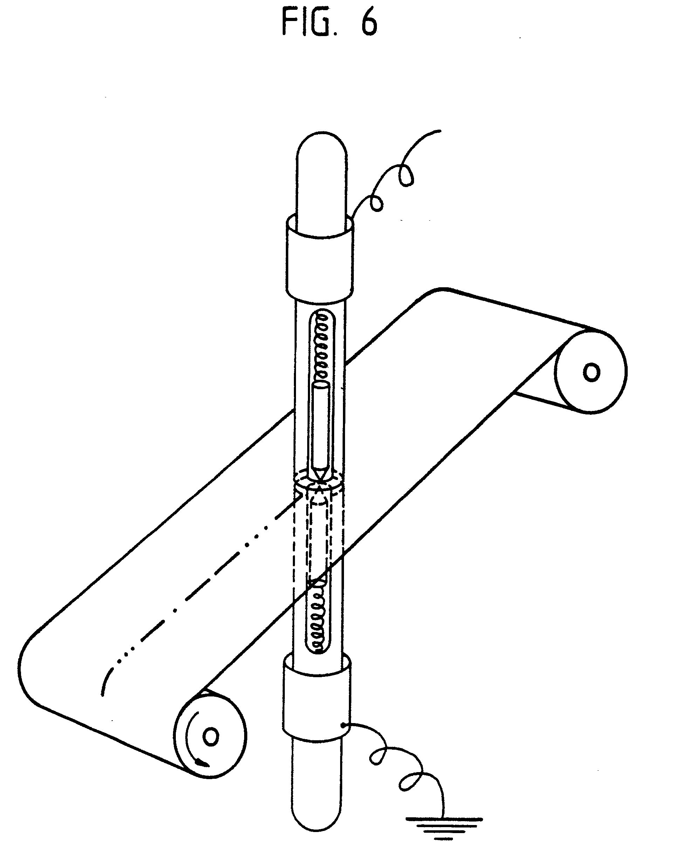

Figur 5 zeigt eine Anordnung zur Durchführung des erfindungsgemäßen Verfahrens. Von einem Hochspannungstransformator ist über die beiden Kondensatoren 1 und 2 (Kapazitäten je etwa $10^{-11}$ Farad) das Schreibelektrodenpaar 3 auf Spannungen von etwa 1 000 bis etwa 40 000 Volt aufladbar. Kondensator und Elektrode bilden jeweils eine Kombinationseinheit, wobei die Elektrode in einem kapillaren einseitig abgeschmolzenen Glasrohr steckt und eine äußere verschiebbare metallische Hülse den Kapazitätszustand leicht anpaßbar zu verändern gestattet (Figur 6). Die Elektrodenspitzen werden dabei durch elastischen Federdruck von beiden Seiten leicht gegen die Oberflächen eines Papierbandes 4 gepreßt, welches kontinuierlich zwischen den beiden Elektroden hindurchgeführt wird. Eine Modulationseinrichtung 5, die im vorliegenden Fall ein einfacher Unterbrecher war, gestattet in vorgebbarer Weise ein Schließen des Hochspannungskreises. Als Trägermatrix dient sog. Millimeterpapier in Form eines 9 Millimeter breiten etwa 5 Meter langen Bandes, welches mit einer etwa 30 Gew.%-igen Lösung von Tolan in Ethanol getränkt und anschließend getrocknet worden war.

Bei längerer Betätigung des Unterbrechers 5 tritt auf dem durchlaufenden Band unmittelbar ein scharfer schwarzbrauner Strich in Erscheinung. Kurzfristige Betätigung liefert dagegen sehr scharfe und außerordentlich feine Punkte (Durchmesser < 0,1 Millimeter). Ober- und Unterseite des Bandes wird dabei in nahezu gleicher Weise gefärbt. Die Betrachtung unter dem Mikroskop zeigt eine gleichmäßige und lokal relativ scharf begrenzte Färbungszone.

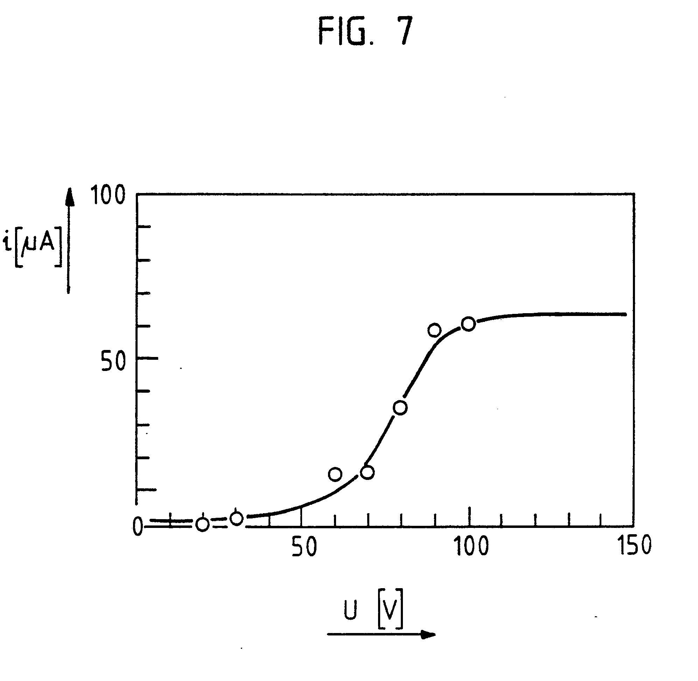

Bei Messung der Leitfähigkeit durch Bestimmung des Stromflusses senkrecht zur Papierfläche ergeben sich in den gefärbten Papierzonen wechselnde Werte, und zwar je nach der einwirkenden Feldstärke von der Leitfähigkeit Null bis zum regelrechten metallischen Kurzschluß, während das nicht durch Reaktionsprodukte verfärbte Papier als Isolator erscheint. Figur 7 zeigt den Zusammenhang zwischen wirksamer Feldstärke, definiert durch die Eingangsspannung des Transformators U in Volt und der Leitfähigkeit, definiert durch den Stromfluß i in μA.

**Patentansprüche**

1. Medium zur irreversiblen Informationsspeicherung durch lokale Änderung der elektrischen Leitfähigkeit eines Trägermaterials, dadurch gekennzeichnet, daß die diskreten Bereiche der elektrischen Leitfähigkeit des Trägermaterials durch feldchemische Umsetzung entstandene polymere Systeme mit konjugierten Doppelbindungen enthalten.

2. Medium zur irreversiblen Informationsspeicherung nach Anspruch 1, dadurch gekennzeichnet, daß die polymeren Systeme mit konjugierten Doppelbindungen Polyacetylene oder Polymere von Acetylenderivaten sind.

3. Verfahren zur irreversiblen Informationsspeicherung mittels feldchemischer Umsetzung, dadurch gekennzeichnet daß zwischen den nadelartigen Spitzen zweier Elektroden auf blatt- oder folienartige Träger aufgebrachte Stoffe durch Einwirkung von zumindest lokalen elektrischen Feldern mit Feldstärken von größer $10^6$ Volt/cm zu polymeren Systemen mit konjugierten Doppelbindungen, die elektrische Leitfähigkeit aufweisen, umgesetzt werden, mit der Maßgabe, daß die Spitzen der Elektroden in einem gegenseitigen Abstand angeordnet sind, welcher mindestens der Dicke des Trägers entspricht und die beiden Elektroden in Reihenschaltung über mindestens einen Kondensator an eine Hochspannungsversorgung von 1000 bis 100 000 Volt angeschlossen sind.

4. Verfahren nach Anspruch 3, dadurch gekennzeichnet, daß die umzusetzenden Stoffe sich in gasförmiger, flüssiger oder fester Form zwischen den das elektrische Feld bestimmenden Elektrodenspitzen und in unmittelbarem Kontakt mit dem Träger befinden.

5. Verfahren nach Anspruch3, dadurch gekennzeichnet, daß die feldchemischen Umsetzungen zu organischen Polymeren mit konjugiertem Doppelbindungssystem führen.

**Claims**

1. A medium for irreversible information storage by locally changing the electrical conductivity of a carrier, wherein the discrete areas of electrical conductivity of the carrier contain polymeric systems which have conjugated double bonds and are formed by a field-chemical reaction.

2. A medium for irreversible information storage as claimed in claim 1, wherein the polymeric system containing conjugated double bonds is a polyacetylene or a polymer of an acetylene derivative.

3. A method for irreversible information storage by means of a field-chemical reaction, wherein substances applied on a sheet-like or film-like carrier are converted, between the needle-like tips of two electrodes by the action of at least local electric fields having strengths greater than $10^6$ volt/cm, to polymeric systems which contain conjugated double bonds and possess electrical conductivity, with the proviso that the tips of the electrodes are arranged a distance apart which is no less than the thickness of the carrier, and the two electrodes are connected in series via one or more capacitors to a high voltage supply of from 1,000 to 100,000 volt.

4. A method as claimed in claim 3, wherein the substances to be reacted are present in gaseous, liquid or solid form between the electrode tips defining the electric field, and in direct contact with the carrier.

5. A method as claimed in claim 3, wherein the field-chemical reaction gives an organic polymer containing a conjugated double bond system.

**Revendications**

1. Moyen de mise en mémoire irréversible d'information par modification locale de la conductivité électrique d'une matière support, caractérisé par le fait que les domaines discrets de conductivité électrique de la matière support contiennent des systèmes polymères à doubles liaisons conjuguées produits par transformation chimique en champ.

2. Moyen de mise en mémoire irréversible d'information selon la revendication 1, caractérisé par le fait que les systèmes polymères à doubles liaisons conjuguées sont des polyacétylènes ou des polymères de dérivés de l'acétylène.

3. Procedé de mise en mémoire irréversible d'information au moyen de transformation chimique en champ, caractérisé par le fait qu'entre les pointes aiguës de deux électrodes, des substances appliquées sur des supports du genre feuille sont, par action de champs électriques au moins locaux de plus de $10^6$ V/cm, transformées en systèmes polymères à doubles liaisons conjuguées qui sont doués de conductibilité électrique, les pointes des électrodes étant à une distance l'une de l'autre au moins égale à l'épaisseur du support et les deux électrodes étant connectées en série par l'intermédiaire d'au moins un condensateur à une alimentation à haute tension de 1000 à 100 000 volts.

4. Procédé selon la revendication 3, caractérisé par le fait que les substances à tranformer se trouvent, à l'état gazeux, liquide ou solide, entre les pointes des électrodes déterminant le champ électrique et en contact direct avec le support.

5. Procédé selon la revendication 3, caractérisé par le fait que les transformations chimiques en champ donnent des systèmes polymères à doubles liaisons conjuguées.

FIG. 1

# FIG. 2

# FIG. 3

FIG. 4

# FIG. 5

# FIG. 6

# FIG. 7